# EUROPÄISCHE PATENTANMELDUNG

(11) **EP 4 756 505 A1**
(43) Veröffentlichungstag der Anmeldung: **10.06.2026**
(21) Anmeldenummer: 25219392.5
(22) Anmeldetag: 28.11.2025
(51) Int. Cl.: G02B 6/13

(54) **VERFAHREN ZUR HERSTELLUNG EINES BAUELEMENTES**

(30) Priorität: 05.12.2024 DE 102024211631
(71) Anmelder: Fraunhofer-Gesellschaft zur Förderung der angewandten Forschung e.V., 80686 München (DE)
(72) Erfinder: Giese, Christian, 79108 Freiburg (DE)
(74) Vertreter: Friese Goeden Patentanwälte PartGmbB

(57) **Zusammenfassung**

Die Erfindung betrifft ein Verfahren zur Herstellung eines Bauelementes (1), enthaltend folgende Schritte: Breitstellen einer Diamantschicht auf einem Substrat (2); Erzeugen von zumindest einem Wellenleiter (3) durch Strukturieren der Diamantschicht; Einbringen von Stickstoff in zumindest ein Teil-volumen (30) des Wellenleiters (3); Erwärmen des Teilvolumens (30), so dass sich zumindest ein NV-Zentrum (4) bildet, wobei das Erwärmen des Teilvolumens (30) durch Widerstands¬heizung erfolgt.

## Beschreibung

Die Erfindung betrifft ein Verfahren zur Herstellung eines Bauelements, enthaltend folgende Schritte: Herstellen einer Diamantschicht auf einem Substrat, Erzeugen von zumindest einem Wellenleiter durch Strukturieren der Diamantschicht, Einbringen von Stickstoff in zumindest ein Teilvolumen des Wellenleiters und Erwärmen zumindest des Teilvolumens, so dass sich zumindest ein NV-Zentrum bildet.

Aus der EP 3 373 023 A1 ist bekannt, eine Mehrzahl von Wellenleitern auf einem Substrat zu erzeugen, welches aus kristallinem Diamant besteht. Nachfolgend werden in diesen Wellenleitern NV-Zentren erzeugt. Jedes NV-Zentrum besteht aus einem Stickstoffatom auf einem Gitterplatz des Diamantgitters und einer benachbarten Leerstelle. Sofern ein solches NV-Zentrum negativ geladen ist, bilden sich zwei ungepaarte Elektronen in einem Triplett-Zustand. Durch die Spin-Spin-Wechselwirkung umfasst dieser Triplet-Zustand einen Singulett-Zustand mit mₛ = 0 und einen zweifach entarteten Dublett-Zustand mit mₛ = ± 1. Durch Anlegen eines Magnetfelds wird die Entartung des Dubletts aufgehoben, so dass die spektroskopische Analyse des NV-Zentrums als Magnetfeldsensor verwendbar ist. Darüber hinaus kann ein NV-Zentrum als Quantenbit bzw. Qubit verwendet werden.

Bei den bekannten Verfahren zur Herstellung von NV-Zentren im Diamantgitter handelt es sich um statistische Prozesse, d.h., es kann im Voraus nicht exakt vorhergesagt werden, an welcher Stelle des Substrats ein oder mehrere NV-Zentren entstehen. Insbesondere die Anwendung von NV-Zentren als Qubit erfordert jedoch die Erzeugung solcher NV-Zentren an genau definierten Stellen bzw. Raumbereichen innerhalb eines Substrats bzw. innerhalb eines Wellenleiters auf oder in einem Substrat.

Ausgehend vom Stand der Technik kann eine mögliche Aufgabe der Erfindung darin bestehen, Farbzentren an vorbestimmten Stellen bzw. innerhalb eines vorgebbaren, kleinen Teilvolumens eines Substrats zu erzeugen.

Die Aufgabe kann in einer Ausführungsform durch ein Verfahren nach Anspruch 1 gelöst werden.

Gemäß einigen Ausführungsformen der Erfindung wird ein Verfahren zur Herstellung eines Bauelements vorgeschlagen. Das nach dem Verfahren hergestellte Bauelement kann dabei zumindest einen Wellenleiter enthalten, in welchem sich optional zumindest ein NV-Zentrum befinden kann. Das Bauelement kann ein Magnetfeldsensor oder Teil eines Quantencomputers sein.

Zur Herstellung des Bauelements kann zunächst eine Diamantschicht auf einem Substrat bereitgestellt werden. Die Diamantschicht kann in einigen Ausführungsformen homoepitaktisch oder heteroepitaktisch auf einem Substrat abgeschieden sein. Zwischen der Diamantschicht und dem Substrat kann sich zumindest eine optionale Zwischenschicht befinden. Das Substrat selbst kann in sich homogen aufgebaut sein. In einigen Ausführungsformen der Erfindung kann das Substrat selbst jedoch wiederum eine oder mehrere Beschichtungen aufweisen. In anderen Ausführungsformen der Erfindung kann die zur Herstellung des Bauelements verwendete Diamantschicht eine physikalisch bzw. geometrisch nicht abgegrenzte Schicht bzw. ein Teilvolumen eines homogenen Diamantsubstrats sein. Nach alledem kann das Substrat ein monokristalliner Diamant sein, welcher entweder in einem HPHT-Verfahren hergestellt wurde oder natürlichen Ursprungs ist. In anderen Ausführungsformen kann ein Diamantsubstrat mittels eines CVD-Verfahrens mit zumindest einer weiteren Diamantschicht überwachsen werden. In wiederum anderen Ausführungsformen der Erfindung kann das Substrat Silizium und/oder Molybdän und/oder Iridium und/oder Strontiumtitanat enthalten oder daraus bestehen, wobei zumindest eine Diamantschicht mittels eines CVD-Verfahrens auf dem Substrat abgeschieden wird.

In einem weiteren optionalen Verfahrensschritt wird zumindest ein Wellenleiter durch Strukturieren der Diamantschicht erzeugt. Dies kann durch nass- oder trockenchemisches Ätzen erfolgen, wobei der zumindest eine Wellenleiter durch einen Fotolack oder eine metallische Maske oder eine andere Maskierungsschicht vor dem Angriff des Ätzmittels geschützt ist. Die Maskierungsschicht kann in einigen Ausführungsformen der Erfindung ein Polymer oder ein Metall oder eine Legierung oder ein Oxid oder ein Nitrid enthalten. Der solchermaßen erzeugte Wellenleiter kann ein Singlemode-Wellenleiter oder ein Multimode-Wellenleiter sein. Der Wellenleiter kann gerade oder gekrümmt verlaufen. Der Wellenleiter kann dazu eingerichtet und bestimmt sein, einem im Wellenleiter befindlichen NV-Zentrum Pumplicht zuzuführen, um dieses vom Grundzustand in einen angeregten Zustand zu überführen. Weiterhin kann der Wellenleiter alternativ oder zusätzlich dazu eingerichtet und bestimmt sein, vom NV-Zentrum ausgehendes Fluoreszenzlicht einem Detektor zuzuführen.

Zur Durchführung des Verfahrens kann Stickstoff in zumindest ein Teilvolumen des Wellenleiters eingebracht werden. In einigen Ausführungsformen der Erfindung können ein oder mehrere Stickstoffatome in an sich bekannter Weise durch Ionisieren, Beschleunigen und Fokussieren in den Wellenleiter implantiert werden. In anderen Ausführungsformen der Erfindung kann der Stickstoff beim Abscheiden der Diamantschicht aus der Gasphase eingebracht werden. Daneben eignet sich jedes andere Verfahren, welches den Einbau von Stickstoff in das Kristallgitter des Diamanten bewirkt. In einigen Ausführungsformen der Erfindung können unvermeidbare Verunreinigungen mit Stickstoff bereits ausreichend sein, um zumindest ein NV-Zentrum zu erzeugen.

Schließlich kann zumindest das Teilvolumen erwärmt werden, so dass sich zumindest ein NV-Zentrum bildet. Die Bildung des NV-Zentrums beruht dabei wesentlich darauf, dass im Kristallgitter befindliche oder erzeugte Vakanzen mobil werden und auf einem zum Stickstoffatom benachbarten Gitterplatz diffundieren, so dass sich dort ein NV-Zentrum bildet. Nach dem Stand der Technik wird stets das gesamte Substrat erwärmt, so dass sich im gesamten Substrat NV-Zentren bilden können, sofern dort Stickstoff vorhanden ist.

In einigen Ausführungsformen der Erfindung kann die Erzeugung von NV-Zentren auf ein vorgebbares Teilvolumen beschränkt werden, wenn nur dieses Teilvolumen oder ggfs. eine Mehrzahl von Teilvolumina erwärmt werden, so dass nur dort die Vakanzen mobil werden und zur Bildung von NV-Zentren führen. In einigen Ausführungsformen der Erfindung wird die Erwärmung demnach so durchgeführt, dass ein oder mehrere erste Teilvolumina des Substrates oder des Wellenleiters auf eine erste Temperatur erwärmt werden, so dass sich dort NV-Zentren bilden, und zweite Teilvolumina des Substrates oder des Wellenleiters auf eine zweite Temperatur gebracht werden, so dass sich dort keine NV-Zentren bilden.

In einigen Ausführungsformen der Erfindung wird vorgeschlagen, diejenigen Stellen bzw. Teilvolumina des Substrats, an welchen NV-Zentren erzeugt werden sollen, durch Widerstandsheizung zu erwärmen. Hierzu kann der Stromfluss über den Wellenleiter bzw. das Substrat so gesteuert, dass an vorbestimmten Stellen Hotspots entstehen, welche zur Erzeugung von NV-Zentren führen, wohingegen die Temperatur im übrigen Volumen so niedrig bleibt, dass sich dort keine NV-Zentren bilden. Da die Widerstandsheizung einfach, rasch und kosteneffizient durchführbar ist, eignet sich das vorgeschlagene Verfahren insbesondere zur Herstellung großer Stückzahlen des Bauelementes.

In einigen Ausführungsformen der Erfindung kann auf zumindest eine Teilfläche des Wellenleiters zumindest eine Metallschicht aufgebracht und mit einer elektrischen Spannungsquelle verbunden werden. Die Metallschicht kann einen Ohm'schen Kontakt oder einen Schottky-Kontakt zum darunterliegenden Diamant des Wellenleiters bilden und auf diese Weise das Teilvolumen des Wellenleiters durch direkten Stromfluss erwärmen. Alternativ oder zusätzlich kann der in der Metallschicht fließende Strom die Metallschicht erwärmen, so dass die in der Metallschicht erzeugte Wärme das darunterliegende Teilvolumen des Wellenleiters erwärmt.

Die Metallschicht kann in einigen Ausführungsformen durch Sputtern oder Aufdampfen oder galvanische oder außenstromlose Abscheidung erzeugt werden. Nach Abschluss des vorgeschlagenen Herstellungsverfahrens kann die Metallschicht wieder von der Oberfläche ganz oder teilweise entfernt werden. In anderen Ausführungsformen der Erfindung kann die Metallschicht auf der Oberfläche des fertigen Bauelements verbleiben.

In einigen Ausführungsformen der Erfindung kann das Strukturieren der Diamantschicht mit einer metallischen Hartmaske erfolgen, welche beim nachfolgenden Erwärmen des Teilvolumens mit einer elektrischen Spannungsquelle verbunden wird. Die metallische Hartmaske weist somit eine doppelte Funktion auf. Einerseits dient diese dazu, den darunterliegenden Diamant vor dem Angriff des Ätzmittels zu schützen und die Herstellung eines Wellenleiters durch nassoder trockenchemisches Ätzen zu ermöglichen. Darüber hinaus kann diese, wie vorstehend beschrieben, dazu dienen, das Teilvolumen, in welchem ein NV-Zentrum hergestellt werden soll, durch Widerstandsheizung zu erwärmen. Auch in diesem Fall kann die metallische Hartmaske nach Abschluss des Herstellungsverfahrens entfernt oder auf dem Bauelement belassen werden.

In einigen Ausführungsformen der Erfindung kann die Metallschicht und/oder die Hartmaske strukturiert werden, so dass deren Querschnitt über zumindest einem Teilvolumen des Wellenleiters reduziert ist. Dies ist insbesondere bei Ausführungsformen hilfreich, bei welchen der Stromfluss innerhalb der durch die Metallschicht definierten Ebene erfolgt. Stellen mit reduziertem Querschnitt innerhalb der Metallschicht weisen einen erhöhten Widerstand auf, so dass dort ein größerer Anteil der elektrischen Leistung in Wärme umgewandelt wird, welche zur Erwärmung des darunterliegenden Teilvolumens beiträgt. Durch die Strukturierung der Metallschicht kann somit die spätere Lage der NV-Zentren innerhalb des Wellenleiters mit hoher Genauigkeit festgelegt werden.

In einigen Ausführungsformen der Erfindung kann das Teilvolumen auf eine erste Temperatur von etwa 700° bis etwa 1000° oder von etwa 800° bis etwa 900° oder von etwa 750° bis etwa 850° erwärmt werden. In einigen Ausführungsformen der Erfindung kann das Substrat bzw. das vorgefertigte Halbzeug des Bauelements beim Erwärmen des zumindest einen Teilvolumens in eine Vakuumkammer eingebracht werden. Hierdurch kann eine Oxidation der Diamantoberfläche und/oder eine Graphitisierung des Diamant vermieden oder reduziert werden, so dass der Wellenleiter eine verbesserte Kristallqualität aufweisen kann.

In einigen Ausführungsformen der Erfindung kann der Wellenleiter über zumindest einen Verbindungssteg mit dem Substrat verbunden sein. In einigen Ausführungsformen kann der Wellenleiter neben den Verbindungsstegen freistehend über dem Substrat angeordnet sein, d.h. zwischen der Unterseite des Wellenleiters und der Oberfläche des Substrats befindet sich ein Spalt. Sofern ein Strom über die Oberfläche des Wellenleiters eingeleitet und über die Substratoberfläche abgeführt wird, konzentriert sich die elektrische Leistungsdichte über den Verbindungsstegen, so dass ein an die Verbindungsstege angrenzendes Teilvolumen jeweils stärker erwärmt wird als das umgebende Material. Somit können einzelne NV-Zentren gezielt in zumindest einem Teilvolumen oberhalb eines Verbindungssteges erzeugt werden.

In einigen Ausführungsformen der Erfindung kann der Verbindungssteg parallel zu der durch die Substratoberfläche definierten Ebene verlaufen. Der Verbindungssteg greift somit seitlich am Wellenleiter an. In anderen Ausführungsformen der Erfindung kann der Verbindungssteg parallel zum Normalenvektor der durch die Substratoberfläche definierten Ebene verlaufen. Der Wellenleiter ist somit ähnlich wie ein Brückenbauwerk mit darunterliegenden Stützen mit der Substratoberfläche verbunden.

In einigen Ausführungsformen der Erfindung kann der Wellenleiter über zumindest eine isolierende Zwischenschicht mit dem Substrat verbunden sein. Hierdurch kann der Betrieb des fertigen Bauelements erleichtert sein. Darüber hinaus kann die Zwischenschicht einen definierten Wärmeübergangswiderstand und/oder einen definierten elektrischen Widerstand zwischen dem Wellenleiter und dem Substrat darstellen, so dass durch Form, Material, Dotierung und/oder Dicke der Zwischenschicht gezielt Teilvolumina des Wellenleiters ausgewählt werden können, welche auf eine höhere Temperatur erwärmt werden als angrenzende Bereiche, so dass in den wärmeren Teilvolumina gezielt NV-Zentren entstehen können.

In einigen Ausführungsformen der Erfindung kann der Wellenleiter und/oder das Substrat zur Widerstandsheizung mit einer Kontaktnadel kontaktiert werden. Die Kontaktnadel kann aus einem metallischen Material bestehen oder ein metallisches Material enthalten. Die Kontaktnadel stellt einerseits einen Übergangswiderstand zum angrenzenden Wellenleiter dar. Darüber hinaus erzeugt der punktförmige Kontakt der Kontaktnadel eine hohe Stromdichte innerhalb des darunterliegenden Diamantmaterials, so dass unterhalb der Kontaktnadel eine höhere Temperatur bzw. eine stärkere Erwärmung vorherrschen kann wie in größerem Abstand zur Kontaktnadel. Durch die räumlich inhomogene Erwärmung kann wiederum der Ort des Entstehens des NV-Zentrums beeinflusst werden.

In einigen Ausführungsformen der Erfindung kann während der Widerstandsheizung Pumplicht in den Wellenleiter eingekoppelt werden, wobei die Widerstandsheizung des Teilvolumens beendet wird, sobald Fluoreszenzlicht des NV-Zentrums nachgewiesen wird. Hierdurch wird der Herstellungsprozess des NV-Zentrums in Echtzeit überwacht, so dass das Entstehen einer unerwünschten Vielzahl von NV-Zentren zuverlässig verhindert werden kann. Vielmehr können durch das vorgeschlagene Verfahren gezielt einzelne NV-Zentren an vorgebbaren Stellen und damit auch in einem vorgebbaren Abstand zueinander erzeugt werden.

In einigen Ausführungsformen der Erfindung kann das Pumplicht mittels einer Laserlichtquelle erzeugt werden. In einigen Ausführungsformen der Erfindung kann das Pumplicht aus dem grünen Spektralbereich stammen. In einigen Ausführungsformen der Erfindung kann das Fluoreszenzlicht dem roten Spektralbereich zuzuordnen sein. Zur Erhöhung der Genauigkeit kann das Fluoreszenzlicht über ein Spektrometer und/oder einen schmalbandigen Filter erfasst werden, um eine Beeinflussung durch das Pumplicht zu vermeiden.

Nachfolgend soll die Erfindung anhand von Figuren ohne Beschränkung des allgemeinen Erfindungsgedankens näher erläutert werden. Dabei zeigt:
Figur 1 einen ersten Querschnitt durch ein Bauelement gemäß einer ersten Ausführungsform.
Figur 2 zeigt einen zweiten Querschnitt durch das Bauelement gemäß der ersten Ausführungsform.
Figur 3 zeigt einen Längsschnitt durch das Bauelement gemäß der ersten Ausführungsform.
Figur 4 zeigt die Aufsicht auf das Bauelement gemäß der ersten Ausführungsformen.
Figur 5 zeigt einen Querschnitt durch ein Bauelement gemäß einer zweiten Ausführungsform.
Figur 6 zeigt einen Querschnitt durch ein Bauelement gemäß einer dritten Ausführungsform.
Figur 7 zeigt eine mögliche Widerstandsheizung gemäß einer vierten Ausführungsform.
Figur 8 zeigt die Echtzeitüberwachung der Widerstandsheizung während der Herstellung des Bauelements.

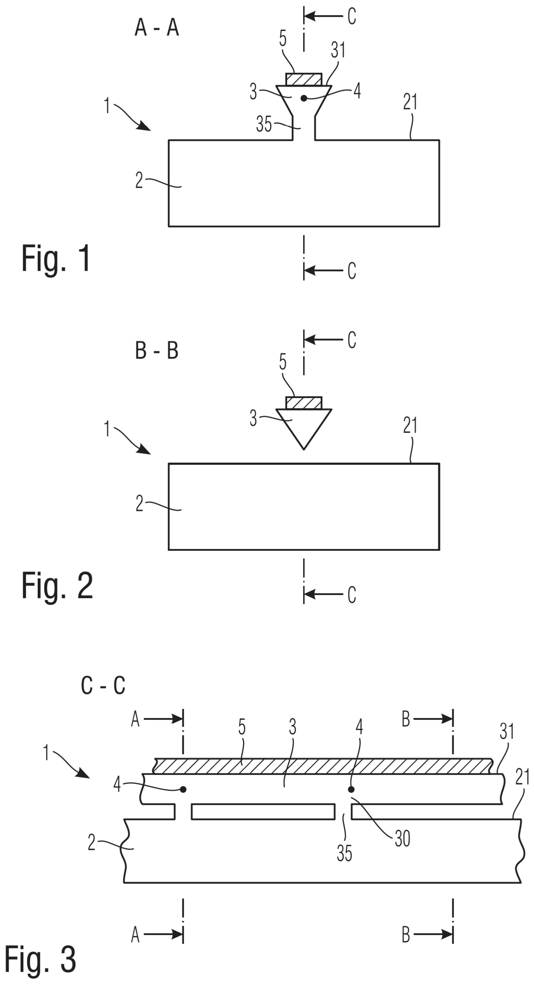

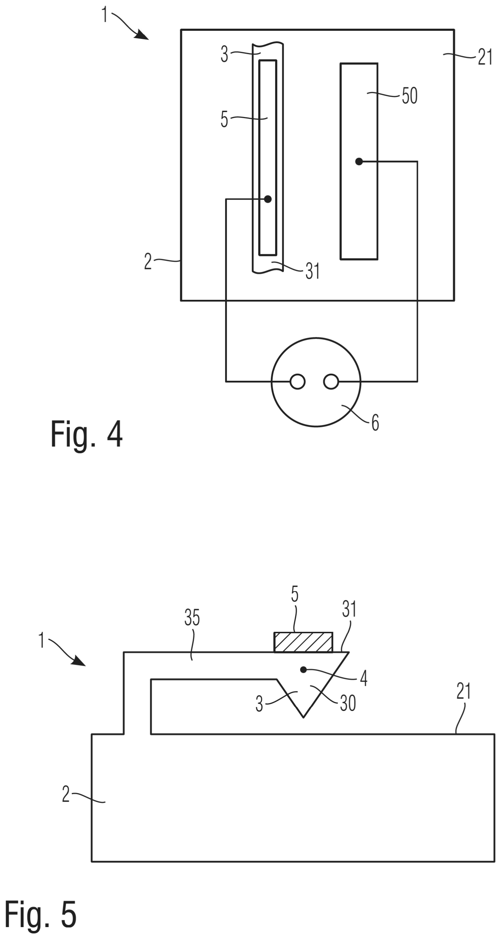

Anhand der Figur 1 bis 4 wird eine erste Ausführungsform der Erfindung näher erläutert. Dabei zeigt Figur 3 einen Längsschnitt durch das Bauelement 1, wohingegen die Figur 1 und 2 zwei unterschiedliche Querschnitte zeigen und Figur 4 die Aufsicht.

Wie aus Figur 3 ersichtlich ist, weist das Bauelement 1 ein Substrat 2 auf. Das Substrat 2 kann Diamant enthalten oder daraus bestehen. Das Substrat 2 kann mit einer homoepitaktisch mittels Niederdrucksynthese erzeugten Diamantschicht überwachsen sein. Alternativ kann das Substrat 2 auch ein Metall oder einen Halbleiter enthalten oder daraus bestehen, insbesondere Silizium, Molybdän, Iridium oder Wolfram. In wiederum anderen Ausführungsformen der Erfindung kann das Substrat 2 eine Keramik enthalten oder daraus bestehen, beispielsweise Strontiumtitanat oder Siliziumcarbid. In jedem Fall weist das Substrat eine Diamantschicht auf, entweder in Form eines oberflächennahen Teilvolumens des an sich homogenen Substrats oder in Form einer homoepitaktisch oder heteroepitaktisch aus der Gasphase abgeschiedenen Diamantschicht.

Wie in den Figur 1 bis 3 ersichtlich ist, wird auf dem Substrat 2 zumindest ein Wellenleiter 3 erzeugt. Die Erzeugung des Wellenleiters 3 erfolgt durch Strukturieren der Diamantschicht, d.h. durch Maskieren und nass- oder trockenchemisches Ätzen. Das Maskieren der Diamantschicht kann dabei mit einer Hartmaske aus Metall oder Keramik erfolgen oder auch mittels eines polymeren Fotolackes. Durch das Strukturieren der Diamantschicht wird zumindest ein Wellenleiter 3 freigestellt, so dass dieser über der Oberfläche 21 des Substrats 2 erhaben ist. Im dargestellten Ausführungsbeispiel weist der Wellenleiter 3 einen dreieckigen Querschnitt auf. In anderen Ausführungsformen der Erfindung kann der Querschnitt des Wellenleiters 3 auch eine andere polygonale oder auch runde Form aufweisen. Der Wellenleiter 3 ist dazu eingerichtet und bestimmt, optische Strahlung, insbesondere sichtbares Licht, durch Totalreflexion an seinen Grenzflächen zu führen, so dass dieses entlang der Längserstreckung des Wellenleiters 3 propagiert.

Im dargestellten Ausführungsbeispiel ist der Wellenleiter 3 über eine Mehrzahl von Verbindungsstegen 35 mit dem Substrat 2 verbunden. Die Verbindungsstege 35 verlaufen dabei parallel zum Normalenvektor der durch die Substratoberfläche 21 definierten Ebene. Die Verbindungsstege 35 liegen somit ähnlich wie Brückenpfeiler unterhalb des Wellenleiters 3. Dies ist in Figur 1 dargestellt. An anderen Stellen entlang seiner Längserstreckung weist der Wellenleiter 3 keine Verbindungsstege 35 auf. Er ist somit beabstandet über der Oberfläche 21 des Substrats 2 angeordnet. Dies ist in Figur 2 dargestellt.

Das Verfahren ist weiterhin dadurch gekennzeichnet, dass Stickstoff in zumindest ein Teilvolumen 30 des Wellenleiters 3 eingebracht wird oder eingebracht ist. Der Stickstoff kann auch homogen im Material des Wellenleiters 3 vorhanden sein. Das Einbringen des Stickstoffs kann vor dem Erzeugen des zumindest einen Wellenleiters 3 erfolgen, beispielsweise durch Implantation. In anderen Ausführungsformen der Erfindung kann der Stickstoff auch aus der Gasphase während der Niederdrucksynthese in die Diamantschicht eingebracht werden. In einigen Ausführungsformen der Erfindung können unvermeidliche Verunreinigungen mit Stickstoff während der Herstellung des Substrates 2 bzw. der Diamantschicht bereits eine hinreichende Konzentration an Stickstoffatomen auf Gitterplätzen innerhalb des Diamant des Wellenleiters 3 hervorrufen.

Im nächsten Verfahrensschritt wird zumindest ein Teilvolumen 30 lokal erwärmt, so dass Vakanzen im Diamantgitter mobil werden und auf einen zu einem Stickstoffatom benachbarten Gitterplatz diffundieren. Hierdurch kommt es zur Bildung von zumindest einem NV-Zentrum im erwärmten Teilvolumen 30. In einigen Ausführungsformen der Erfindung kann genau ein NV-Zentrum in jedem Teilvolumen 30 erzeugt werden.

Das Erwärmen des Teilvolumens 30 erfolgt durch Widerstandsheizung. Hierzu dient zumindest eine Metallschicht 5, welche auf der Oberfläche 31 des Wellenleiters 3 vollflächig oder zumindest als Teilbeschichtung aufgebracht wird. Daneben kann die Oberfläche 21 des Substrats 2 mit einer Gegenelektrode 50 versehen werden. Die Metallschicht 5 und/oder die Gegenelektrode 50 können beispielsweise durch thermisches Aufdampfen oder durch Sputtern oder durch außenstromloses oder galvanisches Abscheiden erzeugt werden. Die Metallschicht 5 und die Gegenelektrode 50 können einen Ohm'schen Kontakt zum darunterliegenden Material ausbilden. In anderen Ausführungsformen der Erfindung können die Metallschicht 5 und/oder die Gegenelektrode 50 einen Schottky-Kontakt zum darunterliegenden Material ausbilden. In einigen Ausführungsformen der Erfindung kann die Gegenelektrode 50 einen größeren Flächeninhalt aufweisen, um die Stromdichte unterhalb der Gegenelektrode 50 und damit den elektrischen Widerstand und die unterhalb der Gegenelektrode 50 erzeugte Wärme gering zu halten.

Wie in Figur 4 gezeigt ist, wird die Metallschicht 5 und die Gegenelektrode 50 mit einer Strom- oder Spannungsquelle 6 verbunden. Auch wenn nachfolgend zur verbesserten Lesbarkeit nur von einer Spannungsquelle die Rede ist, ist eine Stromquelle stets mit von der Beschreibung umfasst. Die Spannungsquelle 6 kann eine Gleich- oder Wechselspannung erzeugen und auf diese Weise einen elektrischen Stromfluss von der Metallschicht 5 über das Material des Wellenleiters 3 und die Verbindungsstege 35 in das Substrat 2 und von dort über die Gegenelektrode 50 zurück zur Spannungsquelle 6 initiieren. Der Stromfluss führt aufgrund des den Materialien inhärenten elektrischen Widerstands zu einer Erwärmung. Die Erwärmung ist umso stärker, je größer der elektrische Widerstand ist und/oder je größer die räumlich inhomogene Stromdichte an einzelnen Stellen ist. Wie aus Figur 3 und Figur 1 ersichtlich ist, fließt der in den Wellenleiter 3 eingeprägte Strom über die Verbindungsstege 35 in das Substrat 2 ab. An der Stelle der Verbindungsstege 35, welche einen im Vergleich zum Wellenleiter 3 geringeren Querschnitt aufweisen, kommt es daher zu einer erhöhten Stromdichte, welche zu einer lokal erhöhten Erwärmung des Wellenleiters 3 führt. Somit kann die Temperatur in den an die Verbindungsstege 35 angrenzenden Teilvolumina 30 lokal so weit ansteigen, dass es dort zur Bildung von NV-Zentren 4 kommt, wohingegen das verbleibende Volumen des Wellenleiters 3 so kühl bleibt, dass dort die Vakanzen im Kristallgitter nicht mobil werden und keine NV-Zentren gebildet werden. Durch die Form, den Querschnitt, die Anzahl und die Lage der Verbindungsstege 35 kann somit die Anzahl und die Position der entstehenden NV-Zentren beeinflusst werden, ohne dass es einer aufwändigen Mikromaterialbearbeitung beispielsweise mittels einer AFM-Spitze oder eines Transmissionselektronenmikroskops bedarf. Durch eine einfache, vergleichsweise große Metallisierung und eine einzige Bestromung kann eine Mehrzahl von NV-Zentren an genau definierten Stellen hergestellt werden.

Die lokale Erwärmung in den Teilvolumina 30 kann dabei zwischen etwa 800°C und etwa 900°C erreichen, wohingegen angrenzende Raumbereiche des Wellenleiters 3 sowie das Substrat 2 wesentlich kühler bleiben, beispielsweise geringer als 700°C. Die Bestromung und nachfolgende Erwärmung kann in einigen Ausführungsformen in einer Schutzgasatmosphäre oder einer Vakuumkammer erfolgen, um eine negative Beeinträchtigung der Kristallqualität des Wellenleiters 3 zu vermeiden, beispielsweise durch Graphitisierung oder Oxidation.

Nach der Herstellung der NV-Zentren kann die Verbindung zur Spannungsquelle 6 entfernt werden. Die Metallschicht 5 und/oder die Gegenelektrode 50 können auf dem Bauelement belassen oder durch nass- oder trockenchemisches Ätzen entfernt werden.

Anhand der Figur 5 wird eine zweite Ausführungsform der Erfindung näher erläutert. Gleiche Bestandteile der Erfindung sind mit gleichen Bezugszeichen versehen, so dass sich die nachfolgende Beschreibung auf die wesentlichen Unterschiede beschränkt.

Figur 5 zeigt einen Querschnitt durch das Bauelement 1 analog zur Figur 1. Wie aus Figur 5 ersichtlich ist, unterscheidet sich die zweite Ausführungsform von der vorstehend beschriebenen ersten Ausführungsform darin, dass der Verbindungssteg 35 parallel zu der durch die Substratoberfläche 21 definierten Ebene verläuft. Hierdurch kann der Verbindungssteg 35 verlängert sein, so dass dieser einen größeren elektrischen Widerstand aufweist und die Wärme im Teilvolumen 30 schneller erzeugt werden kann. Darüber hinaus kann das optische Übersprechen vom Wellenleiter 3 in das Substrat 2 beim späteren Betrieb des Bauelements 1 verringert sein.

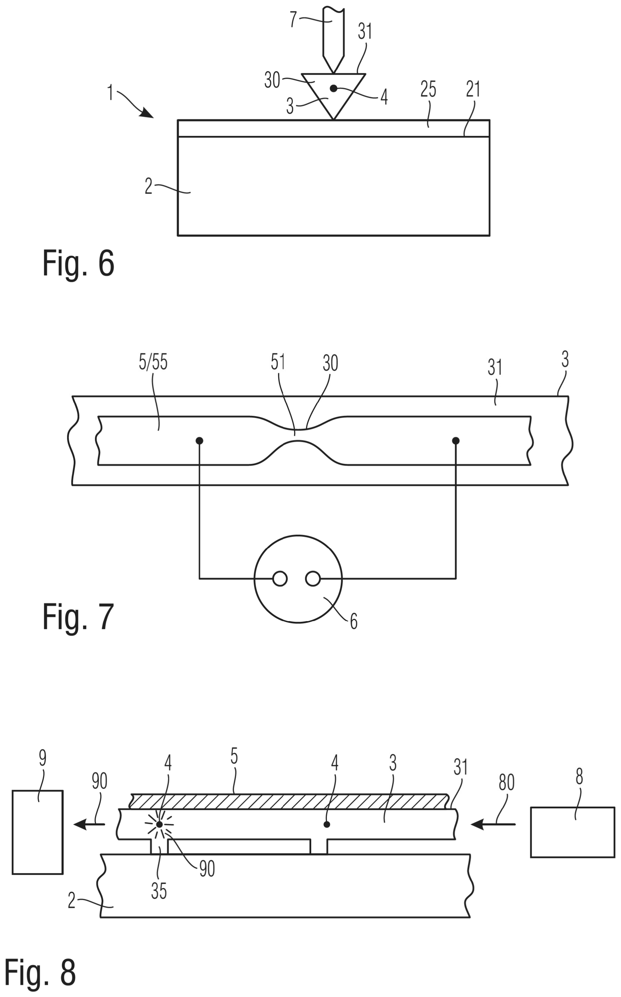

Anhand der Figur 6 wird eine dritte Ausführungsform der Erfindung näher erläutert. Auch in diesem Fall sind gleiche Bestandteile der Erfindung mit gleichen Bezugszeichen versehen. Figur 6 zeigt, dass anstelle der Verbindungsstege 35 eine im Wesentlichen isolierende Zwischenschicht 25 vorhanden ist. Die Zwischenschicht 25 befindet sich auf der ersten Seite 21 des Substrats 2. Die Zwischenschicht 25 kann nominell undotierten Diamant oder Silizium enthalten oder daraus bestehen. Alternativ kann die Zwischenschicht 25 ein Oxid, ein Nitrid oder ein Oxynitrid sein oder ein solches Material enthalten. Die Zwischenschicht 25 kann in einigen Ausführungsformen der Erfindung einen konstanten elektrischen Widerstand zwischen dem Wellenleiter 3 und dem Substrat 2 darstellen. In anderen Ausführungsformen der Erfindung kann die Zwischenschicht 25 einen lokal unterschiedlichen elektrischen Widerstand aufweisen, beispielsweise durch Dotierung oder durch verminderte Schichtdicke. In diesem Fall kann die isolierende Zwischenschicht einen lokal erhöhten Stromfluss in den Teilvolumina 30 und damit eine erhöhte Erwärmung hervorrufen, wie dies vorstehend für die Verbindungsstege 35 bereits beschrieben wurde. In diesem Fall kann der elektrische Strom über eine Metallschicht 5 eingebracht werden, wie vorstehend anhand des ersten Ausführungsbeispiels beschrieben wurde.

In Figur 6 wird eine alternative Form der Widerstandsheizung beschrieben. Hierzu wird der Wellenleiter 3 mit zumindest einer Kontaktnadel 7 kontaktiert. Die Kontaktnadel 7 befindet sich oberhalb eines Teilvolumens 30, so dass dort eine erhöhte Stromdichte und in der Folge eine erhöhte Erwärmung erzeugt wird, welche zur Bildung eines NV-Zentrums 4 führt. Sofern eine Mehrzahl von NV-Zentren erzeugt werden soll, kann eine Mehrzahl von Kontaktnadeln aufgesetzt werden, beispielsweise in Form einer an sich bekannten Nadelkarte mit einer Mehrzahl federnd gelagerter Nadelkontakte.

Es ist darauf hinzuweisen, dass die Widerstandsheizung über zumindest einen Nadelkontakt 7 anstelle der Metallschicht 5 auch mit den vorstehend anhand der Figuren 1 - 5 beschriebenen Ausführungsformen verwendbar ist. Ebenso kann die Zwischenschicht 25 nach Figur 6 auch mit einer Widerstandsheizung über eine Metallschicht 5 gemäß einer der vorstehenden Figuren 1 - 5 kombiniert werden.

Anhand der Figur 7 wird eine weitere Ausführungsform der Erfindung näher erläutert. Gemäß dieser Ausführungsform erfolgt der Stromfluss nicht oder nur zu einem geringen Teil über den Wellenleiter 3 in das darunterliegende Substrat 2. Vielmehr erfolgt der wesentliche Anteil des Stromflusses innerhalb der durch die Metallschicht 5 definierten Ebene und damit entlang der Oberfläche 31 des Wellenleiters 3.

In Figur 7 ist die Verwendung einer Hartmaske 55 auch für die Widerstandsheizung des Wellenleiters 3 gezeigt. Die Hartmaske 55 enthält dabei ein metallisches Material, welches bei der Herstellung des Wellenleiters 3 diesen vor dem Angriff des Ätzmittels schützt. Im Nachgang zur Herstellung des Wellenleiters wird die Hartmaske 55 nochmals maskiert und durch Ätzen teilweise entfernt, so dass sich zumindest eine Engstelle 51 oberhalb des Teilvolumens 30 ausbildet. Der Fachmann wird jedoch erkennen, dass das in Figur 7 dargestellte Verfahren nicht nur mit einer Hartmaske 55 durchgeführt werden kann, sondern in gleicher Weise mit einer dedizierten Metallschicht 5, welche, wie vorstehend beschrieben, ausschließlich zur Widerstandsheizung aufgebracht wurde.

Wie aus Figur 7 ersichtlich ist, weist die Engstelle 51 einen reduzierten Leiterquerschnitt auf, so dass dort der elektrische Widerstand der Hartmaske 55 bzw. der Metallschicht 5 lokal ansteigt. Dies führt zu einer erhöhten elektrischen Verlustleistung und nachfolgend zu einer verstärkten Erwärmung des an die Engstelle 51 angrenzenden Teilvolumens 30, so dass sich dort an einem genau definierten Ort ein NV-Zentrum bilden kann. Diese Form der Widerstandsheizung kann bei allen vorstehend anhand der Figuren 1 - 6 beschriebenen Ausführungsformen des Bauelementes 1 verwendet werden.

Anhand der Figur 8 wird eine Verfahrensalternative näher erläutert, welche mit allen vorstehend beschriebenen Varianten kombinierbar ist. Wie in Figur 8 ersichtlich ist, wird während der Widerstandsheizung des Wellenleiters 3 Pumplicht 80 aus einer Pumplichtquelle 8 in den Wellenleiter 3 eingekoppelt. Die Pumplichtquelle 8 kann eine Laserlichtquelle sein, beispielsweise ein Halbleiterlaser. In einigen Ausführungsformen der Erfindung kann das Pumplicht 80 grünes Laserlicht enthalten oder daraus bestehen.

Das Pumplicht 80 führt zur optischen Anregung eines NV-Zentrums 4, sobald dieses entstanden ist. Das NV-Zentrum relaxiert unter Aussendung von rotem Fluoreszenzlicht mit einer Wellenlänge von etwa 638 nm. Das Fluoreszenzlicht 90 kann in einem Detektor 9 erfasst werden. Der Detektor 9 kann einen schmalbandigen Filter oder ein Spektrometer aufweisen, um die Unterscheidung des Fluoreszenzlichts 90 vom Pumplicht 80 zu ermöglichen.

Sobald das Fluoreszenzlicht 90 im Detektor 9 erfasst wurde, wird die Widerstandsheizung abgeschaltet. Die lokale Erwärmung des kleinen Teilvolumens 30 sinkt sofort unter die zur Entstehung von NV-Zentren benötigte Temperatur ab, da die Wärme aufgrund der hohen Wärmeleitfähigkeit des Diamanten rasch im übrigen Volumen des Wellenleiters 3 verteilt wird. Hierdurch wird die Entstehung weiterer NV-Zentren im Teilvolumen 30 vermieden, so dass sich das Verfahren insbesondere zur Herstellung einzelner NV-Zentren an genau definierten Stellen innerhalb des Wellenleiters 3 eignet.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Die nachfolgenden Ansprüche sind nicht so zu verstehen, dass ein genanntes Merkmal in jeder Ausführungsform der Erfindung vorhanden ist. Sofern die Ansprüche und die vorstehende Beschreibung "erste" und "zweite" Ausführungsformen definieren, so dient diese Bezeichnung der Unterscheidung zweier gleichartiger Ausführungsformen, ohne eine Rangfolge festzulegen.

## Patentansprüche

1. Verfahren zur Herstellung eines Bauelementes (1), enthaltend folgende Schritte:
Bereitstellen einer Diamantschicht auf einem Substrat (2);
Erzeugen von zumindest einem Wellenleiter (3) durch Strukturieren der Diamantschicht;
Einbringen von Stickstoff in zumindest ein Teilvolumen (30) des Wellenleiters (3);
Erwärmen des Teilvolumens (30), so dass sich zumindest ein NV-Zentrum (4) bildet;
**dadurch gekennzeichnet, dass**
das Erwärmen des Teilvolumens (30) durch Widerstandsheizung erfolgt.

2. Verfahren nach Anspruch 1, **dadurch gekennzeichnet, dass** auf zumindest eine Teilfläche (31) des Wellenleiters (3) zumindest eine Metallschicht (5) aufgebracht und mit einer elektrischen Spannungsquelle (6) verbunden wird.

3. Verfahren nach Anspruch 1, **dadurch gekennzeichnet, dass** das Strukturieren der Diamantschicht mit einer metallischen Hartmaske (55) erfolgt, welche beim nachfolgenden Erwärmen des Teilvolumens (30) mit einer elektrischen Spannungsquelle (6) verbunden wird.

4. Verfahren nach einem der Ansprüche 2 oder 3, **dadurch gekennzeichnet, dass** die Metallschicht (5) und/oder die Hartmaske (55) strukturiert wird, so dass deren Querschnitt über dem Teilvolumen (30) reduziert ist.

5. Verfahren nach einem der Ansprüche 1 bis 4, **dadurch gekennzeichnet, dass** der Wellenleiter (3) erste Teilabschnitte aufweist, welche über zumindest einen Verbindungssteg (35) mit dem Substrat (2) verbunden sind und zweite Teilabschnitte aufweist, welche freistehend über dem Substrat (2) angeordnet sind.

6. Verfahren nach Anspruch 5, **dadurch gekennzeichnet, dass** das Teilvolumen (30) an den Verbindungssteg (35) angrenzt.

7. Verfahren nach Anspruch 5 oder 6, **dadurch gekennzeichnet, dass** der Verbindungssteg (35) parallel zu der durch die Substratoberfläche (21) definierten Ebene verläuft oder dass der Verbindungssteg (35) parallel zum Normalenvektor der durch die Substratoberfläche (21) definierten Ebene verläuft.

8. Verfahren nach einem der Ansprüche 1 bis 7, **dadurch gekennzeichnet, dass** der Stromfluss der Widerstandsheizung innerhalb der durch die Metallschicht (5) und/oder die Hartmaske (55) definierten Ebene erfolgt oder
dass der Stromfluss der Widerstandsheizung vom Wellenleiter (3) zum Substrat (2) erfolgt.

9. Verfahren nach einem der Ansprüche 1 bis 6, **dadurch gekennzeichnet, dass** das Einbringen von Stickstoff durch Implantation erfolgt oder
dass das Herstellen einer Diamantschicht mittels Niederdrucksynthese erfolgt und Stickstoff aus der Gasphase eingebracht wird.

10. Verfahren nach einem der Ansprüche 1 bis 9, **dadurch gekennzeichnet, dass** der Wellenleiter (3) über zumindest eine isolierende Zwischenschicht (25) mit dem Substrat (2)verbunden ist.

11. Verfahren nach einem der Ansprüche 1 bis 10, **dadurch gekennzeichnet, dass** der Wellenleiter (3) und/oder das Substrat (2) zur Widerstandsheizung mit einer Kontaktnadel (7) kontaktiert werden.

12. Verfahren nach einem der Ansprüche 1 bis 11, **dadurch gekennzeichnet, dass** während der Widerstandsheizung Pumplicht (80) in den Wellenleiter (3) eingekoppelt wird und die Widerstandsheizung des Teilvolumens (30) beendet wird, sobald Fluoreszenzlicht (90) des NV-Zentrums (4) nachgewiesen wird.
